# EUROPÄISCHE PATENTSCHRIFT

(11) **EP 0 397 029 B1**
(45) Veröffentlichungstag und Bekanntmachung des Hinweises auf die Patenterteilung: **10.02.1993**
(21) Anmeldenummer: 90108364.2
(22) Anmeldetag: 03.05.1990
(51) Int. Cl.: C30B 25/10, C30B 25/14, C23C 16/48

(54) **Werkstückträger für ein scheibenförmiges Werkstück sowie Vakuumprozesskammer**
Carrier for disc shaped workpieces, and vacuum process chamber
Support pour pièces en forme de disque, et chambre pour procédé effectué sous vide

(30) Priorität: 08.05.1989 DE 3915039
(43) Veröffentlichungstag der Anmeldung: 14.11.1990
(73) Patentinhaber: BALZERS AKTIENGESELLSCHAFT, 9496 Balzers (LI)
(72) Erfinder: Wagner, Rudolf, CH-9476 Fontnas (CH); Hirscher, Hans, Dr., CH-7310 Bad Ragaz (CH)
(74) Vertreter: Troesch, Jacques J., Dr. sc. nat.

(56) Entgegenhaltungen:
- DE-A- 3 633 386
- GB-A- 2 114 813
- US-A- 3 717 439
- US-A- 4 565 601
- PATENT ABSTRACTS OF JAPAN, Band 10, nr. 120 (C-343)[2177], 06 Mai 1986; & JP-A-60 245 778

## Beschreibung

Die vorliegende Erfindung betrifft einen Werkstückträger für ein scheibenförmiges Werkstück mit einer Kühl- und/oder Heizeinrichtung, einer von einer Mehrzahl Ausmündungen durchsetzten Werkstückauflage, die mit einem Verteilraum kommuniziert, der seinerseits mit einer Gaszuführleitung verbunden ist, um mit einem dem Verteilraum und zwischen Werkstück und Werkstückauflage zugeführten Gas zwischen letzteren eine polsterähnliche Gasschicht zu bilden, mit dem Gas als Wärmeübertragungsmittel, sowie eine Vakuumprozesskammer zur Behandlung von Werkstücken mit einem solchen Werkstückträger.

Aus der DE-A-36 33 386 ist ein Träger für ein scheibenförmiges Werkstück, nämlich ein Substrat, der eingangs genannten Art bekannt. Für die Behandlung eines solchen scheibenförmigen Substrates in einem Vakuumbehandlungsprozess ist es daraus bekannt, in einen Lagerungsblock eine im wesentlichen der Substratausdehnung entsprechende Einformung vorzusehen, die mit einer zentral angeordneten Gaszuführleitung verbunden ist.

In der genannten Einformung ist eine mehrfach gelochte Scheibe eingelegt, worüber das zu behandelnde Substrat gelegt wird. Es begrenzen somit die erwähnte Scheibe und die Einnehmung im Block einen Verteilraum für das Gas, so dass über die Gaszuführleitung, den genannten Verteilraum und die Ausmündungen aus der genannten Scheibe mit dem Gas zwischen dem Substrat und der durch die Scheibe gebildeten Werkstückauflage ein Gaspolster gebildet wird, mit dem Gas als Wärmeübertragungsmittel.

Bei dieser bekannten Lagerung tritt das das Gaspolster bildende Gas an der Peripherie des Substrates in die Umgebung aus, was insbesondere beim Einsatz einer solchen Lagerung in einem Vakuumbehandlungsprozess für das Substrat oft unerwünscht ist. Wohl wird in manchen Vakuumbehandlungsprozessen dem Prozessraum in definierter Menge ein bestimmtes Gas zugeführt, jedoch ist es in vielen Fällen erwünscht, diese Prozessgaszuleitung unabhängig von einer allfälligen Gaszuführung an der Lagerung zu Wärmeübertragungszwecken vornehmen zu können.

Die vorliegende Erfindung stellt sich zur Aufgabe, an einer Lagerung der obgenannten Gattung zu erreichen, dass das als Wärmeübertragungsmittel eingesetzte Gas im wesentlichen nicht in die Umgebung der Lagerung austritt, und dabei die Lagerung konstruktiv möglichst einfach zu gestalten. Durch Beibehaltung des Einsatzes eines Gases als Wärmeübertragungsmittel soll es dabei möglich bleiben, die Behandlung des Werkstückes bei bestimmten, sehr genau einzuhaltenden Temperaturen durchzuführen.

Diese Aufgabe wird durch eine Lagerung eingangs genannter Art gelöst, die sich nach Anspruch 1 auszeichnet.

Dabei beruht ein Teil der in Anspruch 1 definierten Erfindung gemäss dem Oberbegriff sowie den Merkmalen, und insbesondere dass in der Auflagefläche zusätzlich zu den Austrittsöffnungen eine Vielzahl von Absaugöffnungen münden, die mit einem Gasabsaugraum kommunizieren, an den eine Gasabzugsleitung angeschlossen ist, auf im Rahmen persönlicher und vertraulicher Besprechungen der Erfinder der vorliegenden Teilanmeldung mit Herrn J. Visser, Philips Research Laboratories, Eindhoven, die Niederlande, von letzterem getanen Mitteilungen betreffs des Gegenstandes der DE-Teilanmeldung Nr. 394347.8. Die vorliegende Anmeldung betrifft insbesondere die verbesserte Ausführung des Verteilraums in Form einer oder mehrerer in einer Platte eingearbeiteten Nuten. Dabei ist in diesem Zusammenhang unter dem Begriff "Nut" eine in einem Körper eingearbeitete Einformung zu verstehen, deren Längsausdehnung wesentlich grösser ist als die beiden Ausdehnungen ihrer Querschnittsfläche, d.h. eine kanalähnliche Rinne.

Die Erfindung wird anschliessend beispielsweise anhand von Figuren erläutert.

Es zeigen:
Fig. 1 einen Vertikalschnitt gemäss der Linie II-II in Fig. 2 durch eine Trägeranordnung für ein scheibenförmiges Werkstück, deren verschiedene Stellungen in bezug auf eine durch die Anordnung beschickte Behandlungskammer strichpunktiert dargestellt sind und die einen erfindungsgemässen Träger umfasst.
Fig. 2 eine Draufsicht auf die wesentlichen Teile der Trägeranordnung mit Halteorganen,
Fig. 3 den erfindungsgemässen Werkstückträger an der Anordnung gemäss Fig. 1 im Vertikalschnitt gemäss der Linie III-III von Fig. 4, als Ausschnitt aus Fig. 1 in grösserem Massstab,
Fig. 4 eine Draufsicht auf den Träger gemäss Fig. 3, in einer Hälfte ohne Abdeckplatte dargestellt.

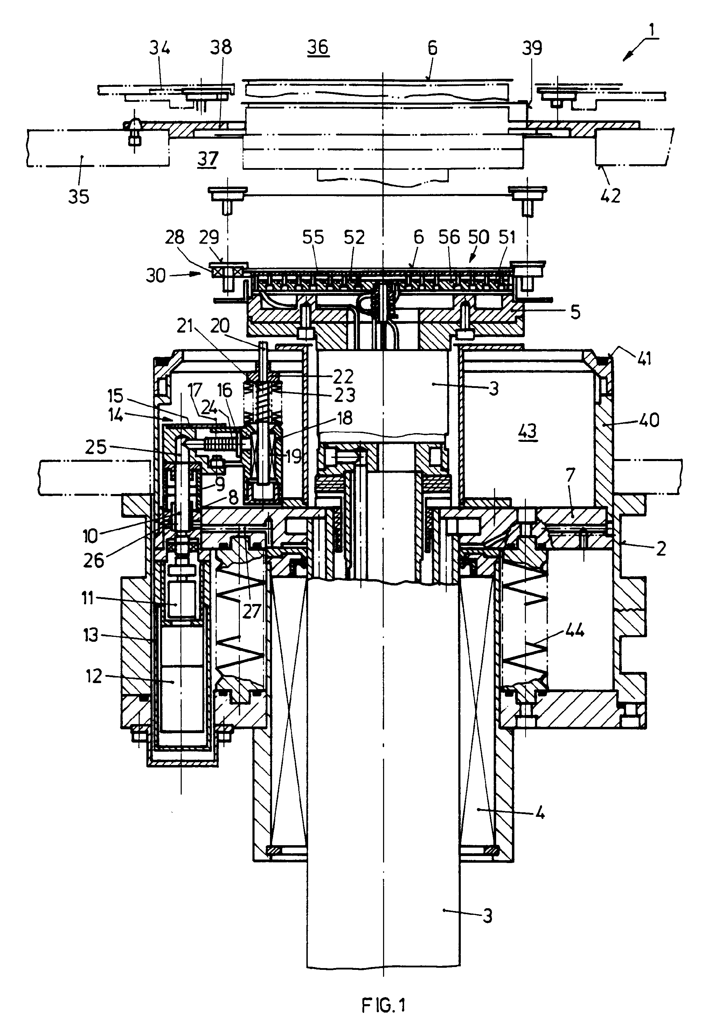

Die in Fig. 1 im Vertikalschnitt dargestellte Trägeranordnung, im weiteren als Hubtisch 1 bezeichnet, weist ein stufenförmig ausgebildetes Gehäuse 2 auf, in welchem eine Säule 3 mittels eines Lagers 4 auf- und abbewegbar gelagert ist. Als Lager dient eine Kugellagerbüchse, die eine nicht dargestellte Einrichtung nach dem Prinzip von zusammenwirkender Nut und Feder besitzt, um die Säule 3 im Gehäuse 2 drehungs sicher zu lagern. Am oberen Ende trägt die Säule 3 eine koaxial zur Achse der Säule angeordnete Werkstücklagerung 5, auf welcher ein scheibenförmiges Werkstück 6 aufliegt. Im Abstand unterhalb der Werkstücklagerung 5 trägt die Säule 3 einen Ringflansch 7, in welchem gemäss Fig. 1 drei umfangsmässig verteilt angeordnete und den Ringflansch durchsetzende Ausnehmungen 8 ausgebildet sind, in welchen jeweils ein Lagerungskörper 9 angeordnet ist. In jedem Lagerungskörper 9 ist eine Welle 10 drehbar gelagert, die an ihrem unteren Ende über Kupplungselemente 11 mit einem Mikromotor 12 verbunden ist. Dieser Mikromotor ist unterhalb des Ringflansches 7 in einem am Ringflansch unterseitig befestigten Gehäuse 13 angeordnet. Am oberen Ende trägt die Welle 10 einen rechtwinklig zur Wellenachse sich erstreckenden zweigleidrigen Auslegerarm 14, der die beiden Glieder 15 und 16 umfasst, die durch eine zur Welle parallele Schwenkachse 17 miteinander verbunden sind, so dass das äussere Auslegerarmglied 16 gegenüber dem oben an der Welle 10 befestigten Auslegerarmglied 15 verschwenkbar ist. Der Auslegerarm 14 trägt am anderen Ende einen Lagerungskörper 18, in welchem mittels einer Kugellagerbuchse 19 eine zur Achse der Welle 10 parallele Stange 20 axial beweglich gelagert ist. Die Stange 20 ist gegen die Wirkung einer die Stange umschliessenden Druckfeder 21 axial verschieblich gehalten, welche die niedergedrückte Stange 20 wieder nach oben bewegt. Zu diesem Zweck ist die Druckfeder 21 mit ihrem unteren Ende am Lagerungskörper 18 abgestützt und mit dem oberen Ende an einem an der Stange befestigten Flansch 22 abgestützt. Am Flansch 22 ist ferner das eine Ende eines Metallfaltenbalgs 23 befestigt, dessen anderes Ende am Lagerungskörper 18 befestigt ist. Dadurch ist innerhalb des Metallfaltenbalgs 23 und des anschliessenden, am unteren Ende geschlossenen Lagerungskörpers 18 ein abgeschlossener Raum vorhanden, in den eine durch den Auslegerarm 14 innen sich hindurcherstreckende flexible Leitung 24 mündet, die flexibel ist, damit sich die beiden Glieder 15 und 16 des Auslegerarms 14 zueinander verschwenken lassen. Die Welle 10 ist hohl, und an diesen Hohlraum 25 ist die flexible Leitung 24 angeschlossen. Am motorseitigen Ende der Welle 10 ist der Hohlraum 25 über Querbohrungen 26 an einen durch den Ringflansch 7 in radialer Richtung sich hindurcherstreckenden Kanal 27 angeschlossen, welcher in nicht dargestellter Weise an eine Vakuumquelle angeschlossen ist, so dass alle vorstehend genannten, in Verbindung miteinander stehenden Räume evakuiert werden können. Eventuell durch Abrieb entstehende Partikel werden abgesaugt und gelangen nicht in den ebenfalls evakuierten Raum, in welchem der Hubtisch arbeitet. Ebenso können auch von den Lagerungen 9 und 19 keine Fremdkörper in diesen Raum gelangen.

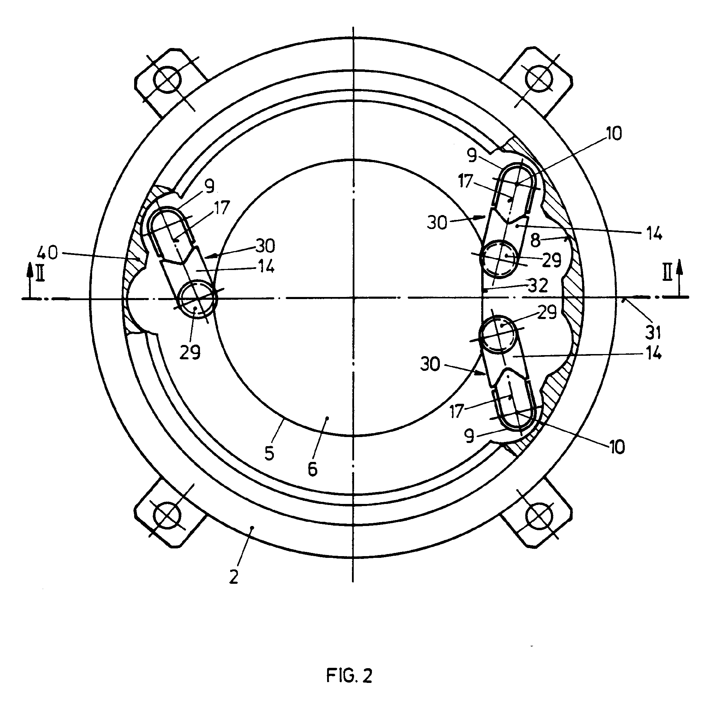

In Fig. 1 ist der Vertikalschnitt durch den Auslegerarm und die anschliessenden Teile in der Zeichenebene liegend dargestellt, jedoch erstreckt sich in Wirklichkeit der Auslegerarm 14 unter einem Winkel zur vertikalen Schnittebene durch den Hubtisch 1, wie aus Fig. 2 hervorgeht, so dass die vorstehend beschriebene Stange 20 in Wirklichkeit seitlich neben der Werkstücklagerung 5 endet und am Ende einen Drehring beispielsweise in Form eines Wälzlagers 28 und oberhalb des Wälzlagers eine Scheibe 29 trägt, die über den Rand des auf der Werkstücklagerung 5 liegenden scheibenförmigen Werkstückes 6 greift, um das Werkstück festzuhalten. Der Drehring 28 ermöglicht die Abwälzbewegung, wenn die Stange 20 durch Verschwenken mittels ihres Drehfusses in Form der Welle 10 bei einer durch den Mikromotor 12 ausgelösten Schwenkbewegung gegen das Werkstück 6 angedrückt wird, um die Lage des Werkstückes auf der Werkstücklagerung zu korrigieren. Die Stange als aktives Organ und alle vorstehend beschriebenen Teile für die Lagerung und Schwenkbewegung der Stange mittels Mikromotor wird nachfolgend als Halteorgan 30 bezeichnet, das noch weitere Funktionen hat.

Wie aus Fig. 2 hervorgeht, sind insgesamt drei Halteorgane 30 vorhanden, von denen eines mit der Stange und der oberen Scheibe 29 auf der Symmetrielinie 31 durch die Werkstücklagerung liegt und zwei weitere Halteorgane 30 beidseits dieser Symmetrielinie und dem einen Halteorgan diametral gegenüberliegen. Wie aus der Draufsicht gemäss Fig. 2 hervorgeht, haben die Scheibenlagerung 5 und das daraufliegende scheibenförmige Werkstück 6 die gleiche Umrissform, nämlich kreisförmig mit einer an einer Seite längs einer Sehne verlaufenden geraden Kante 32. Gegen diese Kante werden zunächst die beiden Halteorgane 30, die zu beiden Seiten der Symmetrielinie 31 liegen, durch Verschwenken der Halteorgane um die Achse der Welle 10 mittels des Motors 12 angedrückt. Man bezeichnet die gerade Kante 32 bei dem scheibenförmigen Werkstück 6 auch als Flat. Anschliessend wird das gegenüberliegende Halteorgan 30 verschwenkt und gegen das Werkstück angedrückt, und wenn dieses ursprünglich mit der geraden Kante 32 nicht genau parallel zu den beiden nebeneinander liegenden Halteorganen 30 auf der Werkstücklagerung positioniert war, so wird es durch das gegenüberliegende Halteorgan zur Anlage gegen die beiden Halteorgane gebracht. Handelt es sich bei dem Werkstück beispielsweise um eine Halbleiterscheibe, so wird dadurch die Scheibenorientierung korrigiert, was für die nachfolgenden Behandlungsschritte wichtig ist.

Die Stellung der Halteorgane in Eingriff ist auch in Fig. 1 in der unteren und in der mittleren Stellung das auf- und abbewegbaren Hubtisches dargestellt, während die durch eine Schwenkbewegung herbeigeführte Stellung ausser Eingriff in Fig. 1 ganz oben dargestellt ist. Das Halteorgan wird demnach nur um einen kleinen Winkel verschwenkt und gelangt in der Stellung, in der es ausser Eingriff ist, unter eine Abdeckung 34, gegen die die Stange 20 beim Hochfahren der Werkstückauflage 5 angedrückt wird, so dass die Stange gegen die Wirkung der Feder 21 einwärts gedrückt wird. In dieser hochgefahrenen Stellung ragt die Werkstückauflage 5 in eine oberhalb einer Vakuumkammerwand 35 befindliche Prozesskammer 36 hinein, wobei die Halteorgane 30 dann unter der Abdeckung 34 geschützt liegen, so dass die in der Prozesskammer 36 stattfindende Behandlung der Werkstückoberfläche, beispielsweise eine Beschichtung mit Aluminium oder ein Aetzprozess, auf die geschützt liegenden Halteorgane sich nicht auswirken kann. Es kann also keine Beschichtung auf den Halteorganen aufwachsen.

Zwischen der Werkstücklagerung 5 und der Vakuumkammerwand 35 ist ein offener Ringspalt 37 vorhanden, der durch einen losen, der Lagerung zugeordneten Ring 38 abgedeckt ist, der am Innenumfang mit mehreren Haken 39 versehen ist, mit denen der Ring 38 am Rand des Werkstückes 6 hängend angeordnet ist, wenn die Werkstücklagerung 5 sich in der hochgefahrenen Stellung befindet. Der Ring dient gleichzeitig als Gewichtsbelastung und fixiert das Werkstück.

Der an der Säule 3 fest angeordnete Ringflansch 7 ist am Aussenrand mit einem zur Säule koaxialen Zylinderkörper 40 fest verbunden, dessen gegenüber der Werkstücklagerung 5 tiefer liegende obere Stirnringfläche 41 als Ventilschliessorgan ausgebildet ist, das gegen eine als Ventilsitz ausgebildete Ringfläche 42 an der Vakuumkammerwand 35 zur Anlage kommt, wenn der Hubtisch in die Bearbeitungsstation hochgefahren ist, so dass in dieser Stellung die Werkstücklagerung 5 in die Bearbeitungs- oder Prozesskammer 36 hineinragt und gleichzeitig diese Kammer gegen den Nachbarraum abgedichtet ist. Zwischen der Säule 3 und dem an dem Ringflansch 7 befestigten Zylinderkörper 40 ist ein Ringraum 43 vorhanden, in dem die wesentlichen Teile der Halteorgane 30 untergebracht sind, von denen sich nur die Stangen 20 nach oben aus dem Ringraum 43 heraus erstrecken.

Ein Metallfaltenbalg 44, dessen oberes Ende unterseitig am Ringflansch 7 und dessen unteres Ende am Boden des Gehäuses 2 befestigt ist, ermöglicht die Auf- und Abbewegung der Werkstücklagerung 5 in einem Raum, der ebenfalls evakuiert wird und der mit dem Raum unterhalb des Ringflansches 7 in Verbindung steht und mittels des Metallfaltenbalges 44 daher von dem übrigen nach unten sich anschliessenden Raum abzutrennen ist.

Der in Fig. 1 dargestellte Hubtisch soll nun erfindungsgemäss ermöglichen, dass eine bestimmte Behandlung eines Werkstückes 6 in der Prozesskammer 36 bei einer bestimmten Temperatur bzw. Temperaturverteilung durchgeführt werden kann, die sehr genau beherrschbar sein soll, z.B. konstant gehalten werden soll.

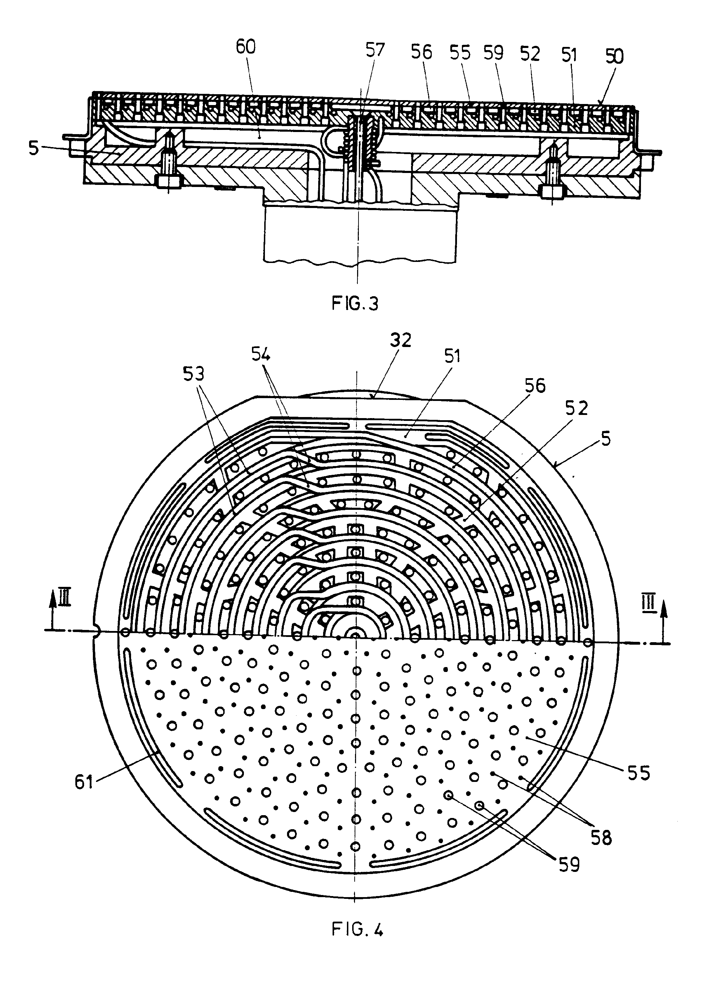

Um die Behandlung mit einer hohen Temperatur durch führen zu können, ist daher der obere Teil der Werkstücklagerung 5 mit einer elektrischen Heizeinrichtung 50 ausgestattet. Diese ist in Fig. 3 in grösserem Massstab im Vertikalschnitt dargestellt. Diese Heizeinrichtung weist eine Platte 51 auf, in der in gleichmässiger Verteilung über die Plattenoberfläche kreisförmige Nuten 52 mit einem stufenartig abgesetzt ausgebildeten Querschnitt ausgebildet sind, wie auch Fig. 4 zeigt.

Die tiefer liegenden Bereiche der Nuten 52, die auf zueinander konzentrischen Kreisen 53 liegen, welche durch Verbindungsabschnitte 54 von einem zum nächsten Kreis in Verbindung stehen, bilden eine vom Zentrum der Platte ausgehend nach aussen auf einem Linienzug verlaufende Rinne zur Aufnahme einer Heizdrahtwendel 56, wie aus Fig. 4 hervorgeht, die in der einen Hälfte der Figur eine Draufsicht auf die Platte 51 zeigt. In der anderen Hälfte der Fig. 4 ist die Draufsicht auf eine weitere Platte 55 dargestellt, welche die Platte 51 abdeckt und mit dieser verbunden ist. Durch diese weitere Platte 55 sind die über die ganze Plattenoberfläche verteilt angeordneten und auch noch in radialer Richtung miteinander in Verbindung stehenden Nuten 52 abgedeckt, so dass Kanäle für die Gasverteilung gebildet werden.

Wie aus Fig. 3 hervorgeht, ist jede Nut 52 im Querschnitt stufenartig abgesetzt ausgebildet und besteht aus einem breiteren oberen und einem schmaleren unteren Bereich, in welchem die elektrische Heizdrahtwendel 56 angeordnet ist, die vom Plattenzentrum bis an den Rand der Platte verläuft. Der obere breitere Nutbereich bildet einen Verteilungsraum, der an einen im Zentrum der Platte in die Nuten 52 mündenden Kanal 57 zum Zuführen von Gas angeschlossen ist. Die Abdeckplatte 55 weist über ihre Oberfläche verteilt, z.B. regelmässig verteilt angeordnet eine Vielzahl von die Platte durchsetzenden kleinen Bohrungen 58 auf, die in die Nuten 52 münden. Durch diese Bohrungen 58 tritt das durch die Nuten 52 strömende Gas aus, um dann zwischen der Oberfläche der Platte 55 und dem darauf liegenden Werkstück eine Gasschicht zu bilden. Das Gas hat dabei die Aufgabe, den Wärmeübertrag von der Oberfläche der Platte 55 zur Rückseite des Werkstückes zu erhöhen. Ausserdem gewährleistet das Gas, dass das Werkstück über seine gesamte Fläche beherrscht, z.B. vollkommen gleichmässig erhitzt wird. Auf diese Weise kann das Werkstück beispielsweise auf 500°C erhitzt werden. Um das Gas wieder abzusaugen, weisen die Platte 51 und die Abdeckplatte 55 über die Plattenoberfläche verteilt, z.B. regelmässig verteilt angeordnet, jedoch neben den Nuten 52 und entlang derselben eine Vielzahl von beide Platten fluchtend durchsetzenden grösseren Bohrungen 59 auf. Diese münden unterhalb der Platte 51 in einen Gasabsaugungsraum 60, von dem aus das Gas weggeführt wird. Schlitzförmige Oeffnungen 61 längs des Plattenrandes dienen ebenfalls zum Gasabsaugen, um sicherzustellen, dass das Gas nicht in den Prozessraum gelangt.

Das zur gleichmässigen Erhitzung des Werkstückes 6 dienende dynamische Gaspolster soll wirksam sein, wenn das mittels des Hubtisches nach oben gefahrene Werkstück sich in der Prozesskammer 36 gemäss Fig. 1 befindet. Damit das Werkstück 6 durch das Gaspolster bzw. die Gasschicht nicht von der Werkstücklagerung 5 abgehoben wird, ist das Werkstück 6 durch das Gewicht des losen Rings 38 belastet, der mit Hilfe der am Ring befestigten Haken 39 am Rand des Werkstückes 6 hängt.

Ohne Betrieb der Heizdrahtspirale dient das Gaspolster und die Gaseinführung und -abführung insbesondere auch zur Kühlung eines Werkstückes bzw. zum Abführen der Wärme.

Gegebenenfalls kann anstelle einer Heizeinrichtung eine Kühleinrichtung vorgesehen werden, z.B. mit Kühlmediumsleitungen anstelle der Heizwendel oder in einer der den Träger bildenden Platten. Im weiteren könnten auch der Gassammelraum oder beide Räume in der gezeigten Nut-Konstruktion aufgebaut sein.

## Patentansprüche

1. Werkstückträger für ein einer Oberflächenbehandlung unterzogenes scheibenförmiges Werkstück, insbesondere in einer Vakuumanlage, mit einer Werkstückauflage, die eine Auflagefläche für das Werkstück bildet, einer Heiz- und/oder Kühleinrichtung, einer Vielzahl in der Auflagefläche verteilt mündender Austrittsöffnungen, die mit einem Verteilraum kommunizieren, und einer an den Verteilraum angeschlossenen Gaszuführung zur Zuführung eines Gases über den Verteilraum und die Austrittsöffnungen zur Bildung einer wärmeübertragenden polsterähnlichen Gasschicht zwischen der Auflagefläche und dem Werkstück, dadurch gekennzeichnet, dass in der Auflagefläche zusätzlich zu den Austrittsöffnungen (58) eine Vielzahl von Absaugöffnungen (59) münden, die mit einem Gasabsaugraum (60) kommunizieren, an den eine Gasabzugsleitung angeschlossen ist und dass mindestens einer der Räume von mindestens einer Nut (52) gebildet ist, die in eine Platte (51) eingearbeitet ist.

2. Werkstückträger nach Anspruch 1, dadurch gekennzeichnet, dass der Verteilraum durch die Nut gebildet ist, die von einer die Werkstückauflage bildenden Abdeckplatte (55) abgedeckt ist.

3. Werkstückträger nach Anspruch 1 oder 2, dadurch gekennzeichnet, dass sich die Nut (52) im wesentlichen in Form konzentrischer Kreise (53) erstreckt.

4. Werkstückträger nach Anspruch 3, dadurch gekennzeichnet, dass die Kreise (53) durch Verbindungsabschnitte (54) im wesentlichen radial miteinander verbunden sind.

5. Werkstückträger nach einem der Ansprüche 1 bis 4, dadurch gekennzeichnet, dass die Nut (52) im Zentrumsbereich der Werkstückauflage (5) mit dem Kanal (57) zum Zuführen von Gas verbunden ist.

6. Werkstückträger nach einem der Ansprüche 1 bis 5, dadurch gekennzeichnet, dass die Platte (51) und eine Abdeckplatte (55) für die Nut miteinander verbunden sind.

7. Werkstückträger nach einem der Ansprüche 1 bis 6, dadurch gekennzeichnet, dass eine Heizwendel (56) an der Platte (51) vorgesehen ist.

8. Werkstückträger nach Anspruch 7, dadurch gekennzeichnet, dass die Heizwendel (56) in der Nut (52) vorgesehen ist.

9. Werkstückträger nach einem der Ansprüche 1 bis 8, dadurch gekennzeichnet, dass der Gasabsaugraum (60) unterhalb der Platte (51) angeordnet ist und sich die Einmündungen (59) in den Gasabsaugraum (60) neben der Nut (52) erstrecken.

10. Werkstückträger nach einem der Ansprüche 1 bis 9, dadurch gekennzeichnet, dass an der Peripherie der Werkstückauflage (5) die Einmündungen (59) als sich ihr entlang erstreckende Schlitze (61) ausgebildet sind.

11. Werkstückträger nach einem der Ansprüche 1 bis 10, dadurch gekennzeichnet, dass ein Haltering (38) für das Werkstück vorgesehen ist, der auf dem Peripheriebereich eines Werkstückes eingreift, um es auf der Auflage (5) zu haltern.

12. Werkstückträger nach Anspruch 11, dadurch gekennzeichnet, dass der Ring (38) mehrere Hakenpartien (39) aufweist, um am Peripheriebereich des Werkstükkes anzugreifen.

13. Werkstückträger nach einem der Ansprüche 11 oder 12, dadurch gekennzeichnet, dass der Ring lose ist und sich mit seinem Gewicht am Werkstück peripher abstützt.

14. Vakuumprozesskammer (36) zur Behandlung von Werkstücken (6) mit einem Werkstückträger nach mindestens einem der Ansprüche 1 bis 13.

## Claims

1. A workpiece carrier for a discoid workpiece subjected to a surface treatment, in particular in a vacuum installation, comprising a workpiece support which forms a support surface for the workpiece, a heating and/or cooling means, a plurality of outlet openings which open in a distributed array in the support surface and which communicate with a distributor chamber, and a gas feed connected to the distributor chamber for feeding a gas by way of the distributor chamber and the outlet openings to form a heat-transmitting cushion-like layer of gas between the support surface and the workpiece, characterised in that in addition to the outlet openings (58), a plurality of suction extraction openings (59) open in the support surface and communicate with a gas suction extraction chamber (60) to which a gas extraction conduit is connected, and at least one of the chambers is formed by at least one groove (52) which is provided in a plate (51).

2. A workpiece carrier according to claim 1 characterised in that the distributor chamber is formed by the groove which is covered by a cover plate (55) forming the workpiece support.

3. A workpiece carrier according to claim 1 or claim 2 characterised in that the groove (52) extends substantially in the form of concentric circles (53).

4. A workpiece carrier according to claim 3 characterised in that the circles (53) are substantially radially connected to each other by connecting portions (54).

5. A workpiece carrier according to one of claims 1 to 4 characterised in that the groove (52) is connected in the central region of the workpiece support (5) to the duct (57) for the feed of gas.

6. A workpiece carrier according to one of claims 1 to 5 characterised in that the plate (51) and a cover plate (55) for the groove are connected together.

7. A workpiece carrier according to one of claims 1 to 6 characterised in that a heating coil (56) is provided on the plate (51).

8. A workpiece carrier according to claim 7 characterised in that the heating coil (56) is provided in the groove (52).

9. A workpiece carrier according to one of claims 1 to 8 characterised in that the gas suction extraction chamber (60) is arranged beneath the plate (51) and mouth orifices (59) into the gas suction extraction chamber (60) extend beside the groove (52).

10. A workpiece carrier according to one of claims 1 to 9 characterised in that at the periphery of the workpiece support (5) the mouth orifices (59) are in the form of slots (61) extending along same.

11. A workpiece carrier according to one of claims 1 to 10 characterised in that there is provided a holding ring (38) for the workpiece, which engages on the peripheral region of a workpiece to hold it on the support (5).

12. A workpiece carrier according to claim 11 characterised in that the ring (38) has a plurality of hook portions (39) for engaging the peripheral region of the workpiece.

13. A workpiece carrier according to one of claims 11 or 12 characterised in that the ring is loose and bears by virtue of its weight on the workpiece at its periphery.

14. A vacuum processing chamber (36) for the treatment of workpieces (6) having a workpiece carrier according to at least one of claims 1 to 13.

## Revendications

1. Support de pièce pour une pièce en forme de disque soumise à un traitement de surface, notamment dans une installation sous vide, comportant un élément d'appui de pièce définissant une surface d'appui pour la pièce, un dispositif de chauffage et/ou de refroidissement, une multiplicité d'orifices de sortie débouchant de façon répartie dans la surface d'appui et communiquant avec un espace de distribution, et une amenée de gaz raccordée à celui-ci et destinée à amener un gaz par l'intermédiaire de l'espace de distribution et des orifices de sortie, pour définir entre la surface d'appui et la pièce une couche gazeuse semblable à un coussin et transmettant la chaleur, caractérisé en ce qu'il est prévu, débouchant dans la surface d'appui, en plus des orifices de sortie (58), une multiplicité d'orifices d'aspiration (59) qui communiquent avec un espace d'aspiration de gaz (60) auquel est raccordée une conduite d'évacuation de gaz, et en ce que l'un au moins des espaces est défini par au moins une rainure (52) qui est ménagée dans une plaque (51).

2. Support de pièce selon la revendication 1, caractérisé en ce que l'espace de distribution est défini par la rainure qui est couverte par une plaque de recouvrement (55) formant l'élément d'appui de pièce.

3. Support de pièce selon la revendication 1 ou 2, caractérisé en ce que la rainure (52) s'étend sensiblement en formant des cercles concentriques (53).

4. Support de pièce selon la revendication 3, caractérisé en ce que les cercles (53) sont reliés entre eux de façon sensiblement radiale par des sections de liaison (54).

5. Support de pièce selon l'une des revendications 1 à 4, caractérisé en ce que la rainures (52) est reliée, dans la zone centrale de l'élément d'appui de pièce (5), au canal (57) destiné à l'amenée de gaz.

6. Support de pièce selon l'une des revendications 1 à 5, caractérisé en ce que la plaque (51) et une plaque de recouvrement (55) prévue pour la rainure sont reliées entre elles.

7. Support de pièce selon l'une des revendications 1 à 6, caractérisé en ce qu'il est prévu un filament chauffant hélicoïdal (56) au niveau de la plaque (51).

8. Support de pièce selon la revendication 7, caractérisé en ce que le filament chauffant hélicoïdal (56) est prévu dans la rainure (52).

9. Support de pièce selon l'une des revendications 1 à 8, caractérisé en ce que l'espace d'aspiration de gaz (60) est disposé au-dessous de la plaque (51), et des orifices (59) débouchant dans l'espace d'aspiration de gaz (60) s'étendent près de la rainure (52).

10. Support de pièce selon l'une des revendications 1 à 9, caractérisé en ce que, à la périphérie de l'élément d'appui de pièce (5), les orifices (59) sont conçus comme des fentes (61) s'étendant le long dudit élément d'appui.

11. Support de pièce selon l'une des revendications 1 à 10, caractérisé en ce qu'il est prévu une bague de retenue (38) pour la pièce, qui vient en prise sur la zone périphérique d'une pièce afin de le tenir sur l'élément d'appui (5).

12. Support de pièce selon la revendication 11, caractérisé en ce que la bague (38) possède plusieurs parties formant crochets (39) afin de venir en prise au niveau de la zone périphérique de la pièce.

13. Support de pièce selon l'un des revendications 11 ou 12, caractérisé en ce que la bague est mobile et s'appuie par son poids, à la périphérie de la pièce.

14. Chambre pour procédé sous vide (36) pour le traitement de pièces (6), comportant un support de pièce selon l'une au moins des revendications 1 à 13.
